# EUROPÄISCHE PATENTANMELDUNG

(11) **EP 1 487 242 A2**
(43) Veröffentlichungstag der Anmeldung: **15.12.2004**
(21) Anmeldenummer: 04090160.5
(22) Anmeldetag: 22.04.2004
(51) Int. Cl.: H05B 33/08

(54) **Elektrische Schaltung für eine direkt modulierte Halbleiterstrahlungsquelle**

(30) Priorität: 06.05.2003 DE 10320333
(71) Anmelder: Infineon Technologies AG, 81669 München (DE)
(72) Erfinder: Schrodinger, Karl, 14089 Berlin (DE)
(74) Vertreter: Müller, Wolfram Hubertus, Dipl.-Phys.

(57) **Zusammenfassung**

Die Erfindung betrifft eine elektrische Schaltung (1) für eine direkt modulierte Halbleiterstrahlungsquelle mit einer Halbleiterstrahlungsquelle (100), der in Abhängigkeit von einem digitalen Datensignal ein modulierter Strom (I_{HL}) zugeführt wird, dessen abfallende Signalflanke ein Peaking aufweist. Erfindungsgemäß sind Schaltungsmittel (20) vorgesehen, die mit einem elektrischen Kontaktpunkt (5) der Schaltung verbunden sind und die bei Unterschreiten eines vorgegebenen Werts der Flussspannung an der Halbleiterstrahlungsquelle (100) das Peaking der abfallenden Signalflanke reduzieren. Hierdurch lassen sich höhere Datenraten erzielen.

## Beschreibung

Die Erfindung betrifft eine elektrische Schaltung für eine direkt modulierte Halbleiterstrahlungsquelle gemäß dem Oberbegriff des Anspruchs 1.

Es ist bekannt, Laserdioden zur Lichterzeugung in optischen Datenübertragüngssystemen einzusetzen. Die optische Ausgangsleistung einer Laserdiode wird dabei durch eine Treiberschaltung festgelegt, die der Laserdiode einen Vorstrom zuführt, der in Abhängigkeit von dem zu übertragenden Datensignal moduliert wird.

Aus der DE 100 65 838 A1 ist eine elektronische Treiberschaltung für direkt modulierte Halbleiterlaser bekannt. Darin wird beschrieben, wie ein konstantes Signal, durch das eine Information transportiert werden soll, durch sogenanntes Peaking überlagert wird. Dieses Peaking beeinflusst die ansteigenden und/oder absteigenden Flanken des Stromes durch den Halbleiterlaser. Das Peaking wird durch eine Treiberschaltung verursacht und bewirkt, dass der Strom durch den Halbleiterlaser und somit die Lichtemission schneller ein- und ausgeschalten werden kann. Dies ermöglicht die Übertragung einer hohen Datenrate durch den Halbleiterlaser.

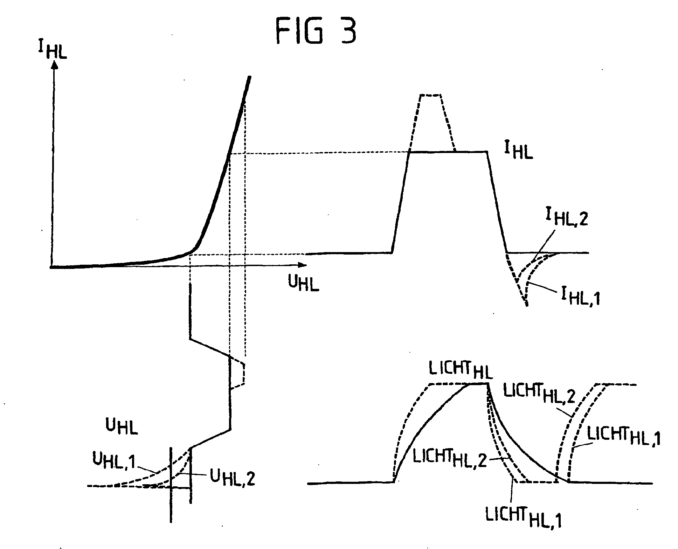

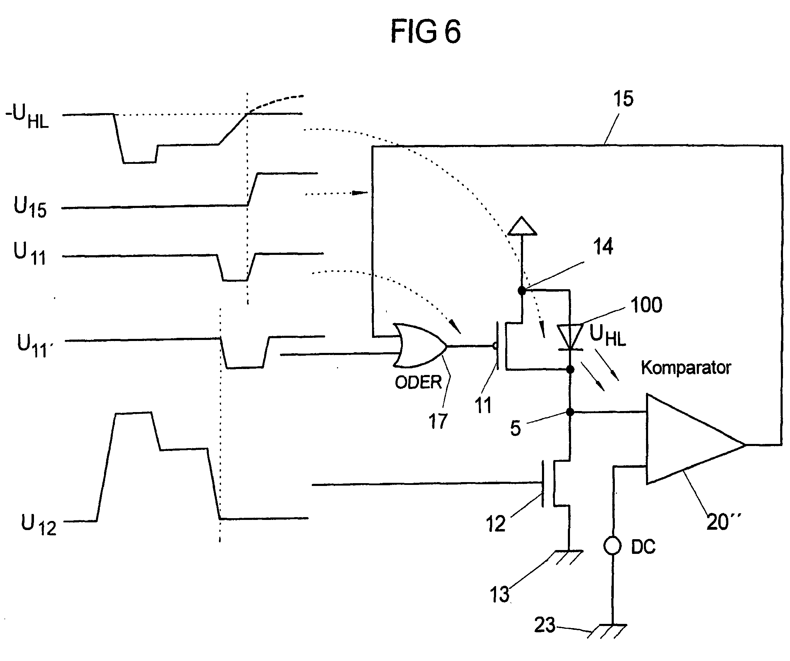

Die aus der DE 100 65 838 A1 entnommenen Figur 5 verdeutlicht das Peaking: In Figur 5 wird schematisch gezeigt, wie dem konstanten Signal der Datenübertragung V_{Dat} eine Spannung Vₚₖ überlagert wird. Diese beiden ergeben den durch den VCSEL-Laser fließenden Strom I_{VCSEL}. Die Spannungspulse V_{Dat} und Vₚₖ sowie die Strompulse I_{VCSEL} sind gegen die Zeit t aufgetragen. In Figur 3 ist schematisch die Lichtstrahlung LICHT_{HL} einer Laserdiode in Abhängigkeit vom Stromfluss I_{HL} durch den Laser gezeigt. Dabei bezieht sich die durchgezogene Linie im Diagramm I_{HL} auf ein nicht durch Peaking moduliertes Datensignal, die gestrichelten Linien 1 und 2 geben das Verhalten des Stromes durch den Laser an, wenn das Signal durch unterschiedlich starkes Peaking moduliert ist. In Figur 3 kann man erkennen, dass durch das Peaking die Ein- und Abschaltflanken der Lichtstrahlung LICHT_{HL} steiler werden, das Laserlicht schneller ein- und ausgeschalten werden kann.

Ein Nachteil der bisher bekannten Schaltung liegt darin, dass das Peaking einen negativen Stromimpuls bereitstellt, durch den die Flussspannung durch die Halbleiterstrahlungsquelle so stark abgesenkt wird, dass beim nächsten Einschalten der Halbleiterstrahlungsquelle (also dem nächsten positiven Strompuls) Einschaltverzögerungen auftreten können. Die Einschaltverzögerungen hängen von der Absenkung der Flussspannung an der Halbleiterstrahlungsquelle ab und entsprechen der Entladung der Diffusionskapazität. Eine exakte Abstimmung des zu verwendenden negativen Strompulses zur Verbesserung der Abschaltflanke erweist sich als technisch nicht praktizierbar, da in den Komponenten der Schaltung gewisse Streuungen der elektrischen und optischen Eigenschaften vorherrschen.

Der Erfindung liegt die Aufgabe zugrunde, ein elektrische Schaltung für eine direkt modulierte Halbleiterstrahlungsquelle zur Verfügung zu stellen, die eine hohe Datenübertragungsgeschwindigkeit durch eine Halbleiterstrahlungsquelle bereitstellen kann. Insbesondere sollen nachteilige Effekte vermieden werden, die durch ein Peaking der abfallenden Signalflanke eines modulierten Stroms durch die Halbleiterlaserdiode entstehen können.

Diese Aufgabe wird erfindungsgemäß durch eine elektronische Schaltung mit den Merkmalen des Anspruchs 1 gelöst. Vorteilhafte und bevorzugte Ausgestaltungen sind in den Unteransprüchen angegeben.

Danach weist die elektrische Schaltung eine Halbleiterstrahlungsquelle auf, der in Abhängigkeit von einem digitalen Datensignal ein modulierter Strom zugeführt wird. Seine abfallenden Signalflanken weisen ein Peaking auf. Durch Schaltungsmittel, die mit einem elektrischen Kontaktpunkt der Schaltung verbunden sind, wird bei Unterschreiten eines vorgegebenen Werts der Flussspannung an der Halbleiterstrahlungsquelle das Peaking der abfallenden Signalflanke reduziert bzw. verhindert. Insbesondere wird bei Unterschreiten des vorgegebenen Werts der Flussspannung die Halbleiterstrahlungsquelle nicht weiter entladen bzw. eine weitere Absenkung der Flussspannung verhindert.

Dadurch wird verhindert, dass sich die Diffusionskapazität der Halbleiterstrahlungsquelle zu stark entlädt bzw. sich an ihr Gegenspannungen bilden. Durch unterschiedlich aufgeladene Diffusionskapazitäten würden unterschiedlich lange Einschaltverzögerungen entstehen, welche unerwünschten Jitter generieren. Die Schaltungsmittel bilden bevorzugt eine Art "Klemmschaltung", die der bestehenden Schaltung an dem elektrischen Kontaktpunkt zugeschaltet wird, oder eine Entladepulssteuerung.

Bevorzugt zeichnen sich die Schaltungsmittel dadurch aus, dass sie den Strom durch die Halbleiterstrahlungsquelle bei Unterschreiten des vorgegebenen Werts der Flussspannung mindestens teilweise umlenken oder abschalten.

In einer bevorzugten Ausgestaltung der Erfindung lassen die Schaltungsmittel den durch die Halbleiterstrahlungsquelle fließenden Strom durch die Schaltungsmittel abfließen, sobald die Spannung an der Halbleiterstrahlungsquelle den vorgegebenen Wert der Flussspannung erreicht. Der Strom durch die Halbleiterstrahlungsquelle wird dadurch umgelenkt und fließt durch die Klemmschaltung ab.

Bevorzugterweise weisen die Schaltungsmittel mindestens einen Transistor auf, der gesperrt ist, solange die an der Halbleiterstrahlungsquelle anliegende Spannung oberhalb des betrachteten vorgegebenen Werts der Flussspannung an der Halbleiterstrahlungsquelle liegt. Der Transistor wird leitend, sobald die Spannung den vorgegebenen Grenzwert erreicht. Dies kann beispielsweise dadurch geschehen, dass ein solcher Transistor beispielsweise ein PNP- bzw. ein NPN-Transistor ist, dessen Basis an einer Gleichspannungsquelle liegt und dessen Emitter mit dem elektrischen Kontaktpunkt zur Halbleiterstrahlungsquelle verbunden ist. In Abhängigkeit von der durch die Gleichspannungsquelle bereitgestellten Spannung wird der Transistor ab einem bestimmten Wert der Flussspannung durch die Halbleiterstrahlungsquelle leitend.

In einer bevorzugten Ausgestaltung der Erfindung weist die Klemmschaltung einen PNP-Transistor und die Halbleiterstrahlungsquelle eine mit einem festen elektrischen Potential verbundene Kathode auf, die mit dem Emitteranschluss des PNP-Transistors verbunden ist. Ab einer gewissen Spannung an der Halbleiterstrahlungsquelle wird ein Strom durch den PNP-Transistor (p-Kanal) gespeist und eine weitere Entladung der Halbleiterstrahlungsquelle vermieden.

Eine zur obigen Ausgestaltungsform analoge Ausgestaltungsform sieht vor, dass die Klemmschaltung einen NPN-Transistor aufweist, und dass die Halbleiterstrahlungsquelle eine mit einem festen elektrischen Potential verbundene Anode aufweist, die mit dem Emitteranschluss des NPN-Transistors verbunden ist. Natürlich können auch Feldeffekttransistoren beliebiger Bauart verwendet werden.

In einer alternativen bevorzugten Ausgestaltung der Erfindung wird das Peaking der abfallenden Signalflanke mittels einer entsprechenden Steuerung der Peaking-Pulse reduziert. Hierzu ist beispielsweise vorgesehen, dass die Schaltungsmittel eine Entladepulssteuerung aufweisen, die bei Unterschreiten eines vorgegebenen Werts der Flussspannung einer ein Peaking bereitstellenden Schaltung ein Spannungs- oder Stromsignal zuführen, das ein Abschalten des Peakings der betrachteten Flanke bewirkt, d.h. der negative Pulsstrom wird mittels einer Abschaltung vorzeitig beendet. Auch auf diese Weise kann eine weitere Entladung der Halbleiterstrahlungsquelle verhindert werden. Die ein Peaking bereitstellende Schaltung weist beispielsweise einen Transistor auf, wobei das Spannungssignal der Basis des Transistors zugeführt wird.

Die Schaltungsmittel bzw. die Klemmschaltung misst in gewisser Weise die an der Halbleiterstrahlungsquelle anliegende Spannung oder den durch sie fließende Strom. Wenn die gemessene Spannung bzw. der gemessene Strom einen vorgegebenen Wert unterschreitet, wird der Strom in die Klemmspannung abgeleitet oder der negative Pulsstrom mittels einer Abschaltung vorzeitig beendet. Das "Messen" der Spannung bzw. des Stroms erfolgt dabei ggf. insofern automatisch, als bei Ereichen eines betrachteten Grenzwerts eine Schaltung aktiviert wird. Es kann grundsätzlich jedoch auch vorgesehen sein, dass zunächst ein Messsignal ermittelt und dieses dann einer Steuerschaltung zugeführt wird.

Eine weitere bevorzugte Ausgestaltungsform sieht vor, dass die Klemmschaltung mindestens einen elektrischen Kontaktpunkt zu einer Schaltung mit einem direkt modulierten VCSEL-Laser aufweist. Diese Laser eignen sich besonders zur schnellen Datenübertragung. Bevorzugt kann die Halbleiterstrahlungsquelle auch eine Leuchtdiode sein.

Bevorzugterweise weist die Klemmschaltung eine elektrische Verbindung zu einem konstanten Potentialpunkt auf, insbesondere zu einer elektrischen Masse. Dieser elektrische Kontaktpunkt zu einem konstanten Potential wird dazu genutzt, den durch die Halbleiterstrahlungsquelle fließenden Strom ggf. über die Klemmschaltung zum konstanten Potentialpunkt abzuleiten.

Die Erfindung wird nachfolgend unter Bezugnahme auf die Figuren der Zeichnung an mehreren Ausführungsbeispielen näher erläutert. Es zeigen:
- Figur 1: ein Schaltbild einer modulierten Halbleiterstrahlungsquelle mit einer schematisch dargestellten Entladepulssteuerung;
- Figur 2: ein Schaltbild einer modulierten Halbleiterstrahlungsquelle mit einem Ausführungsbeispiel einer Klemmschaltung;
- Figur 3: eine Strom-Spannungs-Kennlinie einer Halbleiterstrahlungsquelle zusammen mit den zugehörigen Signalpulsformen für Strom, Spannung und Licht;
- Figur 4: ein Schaltbild einer modulierten Halbleiterstrahlungsquelle gemäß dem Stand der Technik;
- Figur 5: die zeitliche Abfolge von gepeakten Pulsen in einer Treiberschaltung für eine Halbleiterstrahlungsquelle gemäß dem Stand der Technik; und
- Figur 6: ein Ausführungsbeispiel einer modulierten Halbleiterstrahlungsquelle mit einer Entladepulssteuerung.

Die zeitliche Abfolge der Strom- bzw. Spannungspulse beim bekannten Peaking wurde eingangs anhand der Figur 5 erklärt.

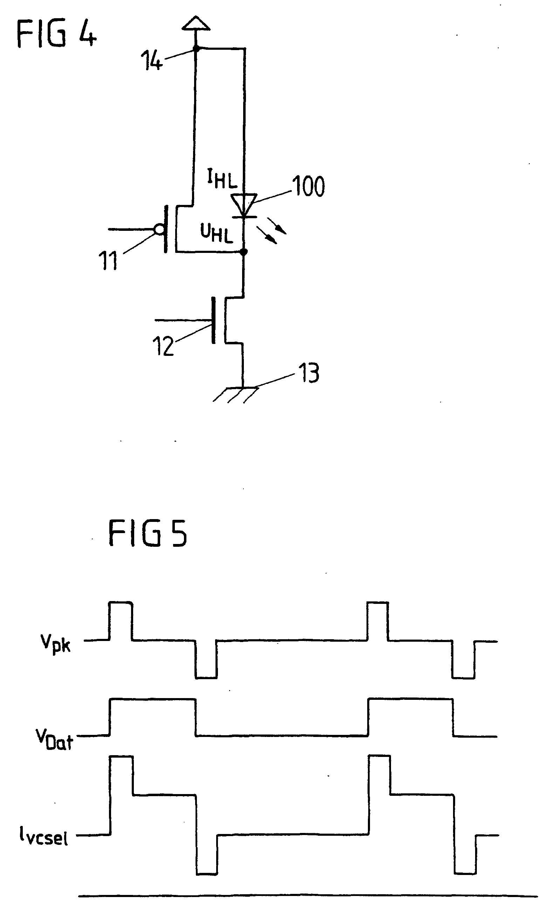

Die Figur 4 zeigt ein bekanntes Schaltbild einer modulierten Halbleiterstrahlungsquelle 100. In diesem Schaltbild ist die Halbleiterstrahlungsquelle 100 eine LED mit einer Anode und Kathode. Ebenso kann es sich um eine beliebige Laserdiode handeln. Die LED 100 wird über eine modulierte Stromquelle 12 mit einem entsprechend einem zu übertragenden Signal modulierten Strom I_{HL} beaufschlagt. Über einen Transistor 11 werden zusätzlich Peaking-Pulse bereitgestellt, die ein Peaking der Flanken des Stroms durch die LED 100 bewirken, wie in Figur 5 dargestellt.

Wichtig für eine schnelle Datenübertragung sind die Form besonders der Einschalt- und Abschaltflanken des Signals des Stroms I_{HL} durch die Halbleiterstrahlungsquelle 100 und die Spannung an der Halbleiterstrahlungsquelle 100.

In Figur 3 werden die Strom-Spannungs-Kennlinie an der Halbleiterstrahlungsquelle 100 der Figur 4 gezeigt, sowie die Signalpulsformen für Strom, Spannung und Licht der Halbleiterstrahlungsquelle.

Dabei ist der Strom I_{HL} durch die Halbleiterstrahlungsquelle in Abhängigkeit von der Spannung U_{HL} gezeigt. Wie üblich weist die Kennlinie einer Diode bei niedrigen Spannungen U_{HL} einen sehr sanften Stromanstieg auf, ab einem gewissen Grenzwert jedoch steigt der Strom I_{HL} im wesentlichen linear an. Dieser lineare Bereich stellt den gewünschten Arbeitsbereich der Halbleiterstrahlungsquelle dar: unterhalb des Bereichs des linearen, steilen Anstiegs des Stroms sollte die Spannung U_{HL} bzw. der Strom I_{HL} nicht fallen. Eine kleinere an der Halbleiterstrahlungsquelle anliegende Spannung würde bei einem Einschalten der Halbleiterlichtquelle eine Verzögerung bedeuten, da die zur Lichtemission an der Halbleiterstrahlungsquelle 100 notwendige Spannung erst aufgebaut werden müsste. Deswegen ist es wünschenswert, eine gewisse Restspannung an der Halbleiterstrahlungsquelle zu erhalten.

Rechts oben neben der Kennlinie ist die Signalpulsform für den Strom I_{HL} der Kennlinie gezeigt. Die durchgezogene Linie zeigt eine normale, im Wesentlichen rechteckige Signalform, die kein Peaking aufweist. Die gestrichelten Linien beziehen sich auf eine durch Peaking modulierte Signalpulsform. Dabei wird sowohl beim Einschalten als auch beim Abschalten des Signals ein zusätzlicher Strompuls durch die Halbleiterstrahlungsquelle bereitgestellt.

Dementsprechend sind eine überhöhte Einschaltflanke mit im Wesentlichen rechteckiger Form und eine besonders tief abfallende Abschaltflanke mit im Wesentlichen dreieckiger Form unterhalb des gewünschten Arbeitsbereiches der Halbleiterstrahlungsquelle vorgesehen.

Die Lichtleistung der Halbleiterstrahlungsquelle ist in Figur 3 rechts unten dargestellt. Zur Verbesserung der Steilheit der Abschaltflanke der Lichtstrahlung LICHT_{HL} der Halbleiterstrahlungsquelle wird eine negative Spannung U_{HL} an die Halbleiterstrahlungsquelle angelegt. Je nach Höhe dieses negativen Stromes ergeben sich die in Figur 3 gezeigten Pulsformen I_{HL,1} bzw. I_{HL,2}. Die erste Pulsform I_{HL,1} hat dabei eine größere negative Stromhöhe als die zweite Pulsform I_{HL,2}.

Weiter ist in Figur 3 unten links die zugehörige Signalpulsform der Spannung U_{HL,1,2} gezeigt. Auch hier zeigt die durchgezogene im Wesentlichen rechteckige Signalpulsform die Spannung U_{HL} für eine nicht zusätzlich durch Peaking modulierte Halbleiterstrahlungsquelle. Die gestrichelten Linien U_{HL,1,2} geben die Pulsform für ein moduliertes Signal an und weisen wie beim Strom I_{HL} eine im Wesentlichen rechteckige Form bei der Einschaltflanke und eine im Wesentlichen dreieckige Form in unterschiedlicher Stärke bei der Abschaltflanke auf.

Rechts unten in Figur 3 ist wie erwähnt das zu den beiden Signalpulsformen für I_{HL} und U_{HL} gehörige von der Halbleiterstrahlungsquelle emittierte Lichtstrahlung LICHT_{HL} gezeigt. Hier erkennt man, dass bei einem nicht durch Peaking modulierten Signal (durchgezogenen Linie) die Leistung der Lichtstrahlung LICHT_{HL} keine annähernd rechteckige Form aufweist, sondern flache Einschalt- und Abschaltflanken. Diese Einschalt- und Abschaltflanken werden bei durch Peaking modulierten Signalpulsformen steiler (gestrichelte Linien). Dabei ist die Abschaltflanke umso steiler, je größer die negative Höhe der Gegenstroms beim Abschalten des Signalpulses war. Die erste Pulsform LICHT_{HL,1} zeigt deswegen eine steilere Flanke als die zweite Pulsform LICHT_{HL,2}.

Des weiteren ist in der Darstellung der Lichtleistung die Einschaltflanke für ein folgendes Pulssignal gezeigt. Hierbei fällt auf, dass das Signal mit der zweiten, weniger stark abfallenden Pulsform LICHT_{HL,2} zu einem früheren Zeitpunkt wieder eingeschaltet werden kann als das Signal mit der ersten Pulsform LICHT_{HL,1} mit der größeren negativen Stromhöhe beim Abschalten des Pulssignals. So verzögert bei der ersten Pulsform ein negativer Gegenstrom das schnelle Wiedereinschalten des Lichtes der Halbleiterstrahlungsquelle. Durch die nachfolgend beschriebenen Schaltungen wird dieser negative Effekt des an sich erwünschten Peakings verhindert bzw. vermindert.

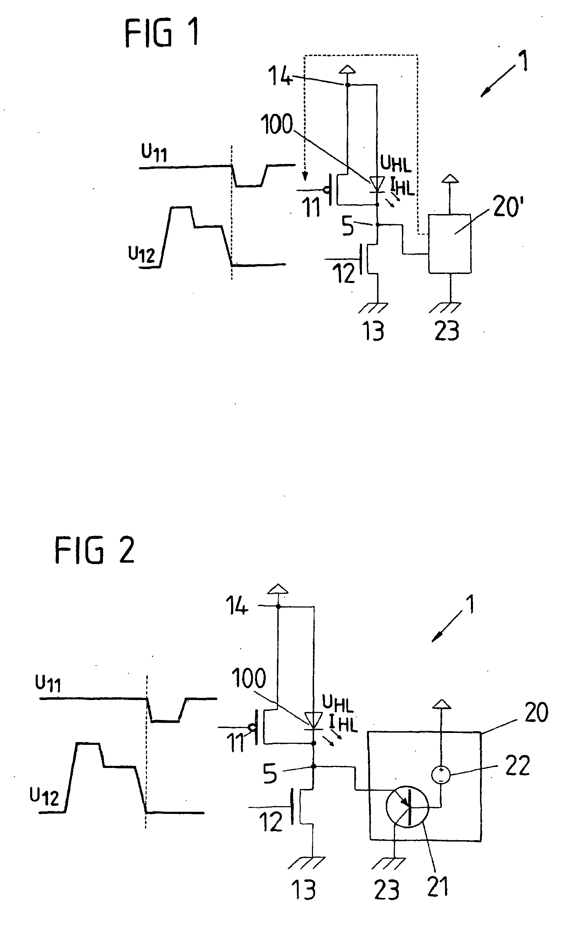

Die Figur 1 zeigt ein Schaltbild einer modulierten Halbleiterstrahlungsquelle 100 mit einer schematisch dargestellten Entladepulssteuerung 20'.

Die in Figur 1 dargestellte Schaltung entspricht bis auf die Entladepulssteuerung 20' der Schaltung der Figur 4. Dem Transistor 12, der als Stromquelle der Schaltung dient, wird an seinem Gate-Anschluss ein Spannungssignal U₁₂ zugeführt. Dieses ist entsprechend den zu übertragenen Daten moduliert und weist darüberhinaus an der jeweils ansteigenden Flanke eines Spannungspulses ein Peaking-Signal auf. Der durch die Halbleiterstrahlungsquelle fließende Strom ist entsprechend moduliert, vgl. Figur 3.

An dem weiteren Transistor 11 werden negative Peaking-Pulse U₁₁ für die abfallende Flanke des Stromsignals bereitgestellt. Der Transistor 11 ist Teil eines an sich bekannten Schaltkreises zur Erzeugung von Peaking-Pulsen, so dass auf diese Schaltung nicht weiter eingegangen wird.

Die Entladepulssteuerung 20' ist über einen Kontaktpunkt 5 mit der Kathode der Halbleiterstrahlungsquelle 100 verbunden und weist weiterhin eine elektrische Verbindung zu einem konstanten Potentialpunkt 23 auf, hier der elektrischen Masse.

Die Entladepulssteuerung 20' verhindert ein zu starkes Peaking der abfallenden Signalflanke eines Strompulses durch die Halbleiterstrahlungsquelle. Hierzu wird seitens der Entladepulssteuerung 20' die Spannung an der Halbleiterstrahlungsquelle 100 gemessen. Bei Erreichen eines bestimmten Wertes wird die Peaking-Schaltung für die betrachtete abfallende Flanke deaktiviert. Somit wird ab einem bestimmten Punkt eine weitere Entladung der Halbleiterstrahlungsquelle verhindert. Dieser Aussage entspricht, dass die Flussspannung U_{HL} der Halbleiterstrahlungsquelle 100 nicht zu stark abfällt, insbesondere nicht unterhalb des Bereichs des linearen Anstiegs der Strom-Spannungs-Kennlinie der Figur 3 fällt.

Wie in Figur 1 durch eine gestrichelte Linie gezeigt, ist dabei eine Verbindung der Entladepulssteuerung 20' mit dem Transistor 11 der Peaking-Schaltung vorgesehen. Mit dieser Verbindung kann der Peaking-Schaltung durch die Entladepulssteuerung 20' ein Strom- oder Spannungssignal zugeführt werden, das die Peaking-Schaltung für die betrachtete abfallende Flanke deaktiviert, so dass der negative Strompuls durch das Halbleiterbauelement an der abfallenden Flanke begrenzt wird. Bei Unterschreiten der Schwellspannung wird der negative Pulstrom mittels einer Abschaltung also vorzeitig beendet.

Die Entladepulssteuerung der Figur 1 und die auftretenden Spannungen sind in Figur 6 in einem Ausführungsbeispiel näher dargestellt. Die Entladepulssteuerung weist einen Komparator 20'' auf, der die Spannung am Knotenpunkt 5 mit einem vorgegebenen Spannungswert vergleicht. Der Komparator 20" weist zwei Eingänge auf, die mit zwei Vergleichspannungen verbunden sind. Am ersten Eingang liegt über den Kontaktpunkt 5 die Spannung U_{HL} der Halbleiterstrahlungsquelle 100 an. Diese wird mit einem vorgegebenen Schwellwert verglichen. Der Schwellwert wird durch eine Gleichspannungsquelle DC eingestellt, die mit dem zweiten Eingang des Komparators 20" verbunden ist.

Unterschreitet die Spannung U_{HL} an der Halbleiterstrahlungsquelle 100 den vorgegebenen Schwellwert, so entsteht ein Steuersignal, dass über eine Verbindung 15 einem ersten Eingang eines logischen ODER-Elementes 17 zugeführt wird, das dem Transistor 11 der Peaking-Schaltung vorgeschaltet ist. Die Form dieses Signals gibt der Spannungsverluag U₁₅ an. An einem zweiten Eingang des ODER-Elementes 17 liegt eine Spannung U₁₁' an, die das Peaking-Signal des Abschaltvorganges bereitstellt. Die beiden Signalspannungen U₁₁' und U₁₅ bestimmen die Ausgangsspannung U₁₁, die über den Ausgang des ODER-Elementes an dem Transistor 11 anliegt.

Die Funktionsweise wird anhand der Spannungen U₁₂, U₁₁', U₁₁, U₁₅ und -U_{HL} erläutert. Während des Spannungspulses U₁₂, der das zu übertragenden Datensignal enthält, liegt die Spannung U₁₁' auf logisch EINS, die Spannung U₁₅ auf logisch NULL. Damit liegt die Spannung U₁₁ logisch EINS am Ausgang des ODER-Elementes 17 und am Transistor 11. Der Transistor 11 sperrt für diesen Fall. Für ein negatives Peaking der Abschaltflanke des Lichtsignals wird nun nach Beendigung des Signals U₁₂ das Signal U₁₁' durch die Peaking-Schaltung auf logisch NULL gestellt. Damit liegt an beiden Eingängen des ODER-Elementes 17 das Signal logisches NULL an. Der Transistor 11 ist dann leitend. Die Spannung an der Halbleiterstrahlungsquelle 100 kann über den Transistor 11 abgebaut werden.

Erreicht nun die Spannung U_{HL} an der Halbleiterstrahlungsquelle 100 den vorgegebenen Schwellwert, so wird durch den Komparatorausgang das Signal U₁₅ auf logisch EINS gesetzt. Dies bewirkt, dass der Ausgang des ODER-Elementes 17 ebenfalls auf logisch EINS gesetzt wird: der Transistor 11 sperrt nun und es wird eine weitere Entladung der Halbleiterstrahlungsquelle 100 verhindert. Über den Komparator 20" wird also ein vorzeitiges Ende des negativen Pulses U₁₁' bewirkt.

Sobald die Spannung U_{HL} an der Halbleiterstrahlungsquelle 100 den Schwellwert erreicht, bleibt sie bis zum nächsten positiven Puls auf diesem Wert. Ohne ein Abschalten des negativen Pulses U₁₁' durch den Komparator würde sie weiter abfallen (gestrichelte Linie). Dann würde sich die Diffusionskapazität der Halbleiterstrahlungsquelle zu stark entladen.

Der Komparators 20" weist bevorzugt eine Hysterese auf, die ein Schwingen des Systems im Low Pegel verhindert, während die Spannung U_{HL} nahe am vorgegebenen Schwellwert liegt. Ferner wird der Komparator so gesteuert, dass er nur bei der Abschaltflanke des Signals aktiviert werden kann.

In der Figur 2 ist ein Schaltbild einer alternativen modulierten Halbleiterstrahlungsquelle 100 mit einer Klemmschaltung 20 zu sehen, die die Entladepulssteuerung 20' der Figur 1 ersetzt. Ansonsten entspricht die Schaltung der Figur 2 der Schaltung der Figur 1.

Die Klemmschaltung 20 überwacht die Flussspannung durch die Halbleiterstrahlungsquelle 100. Bei Unterschreiten einer bestimmten Flussspannung, d.h. ab einem bestimmten Wert der Flussspannung an der abfallenden Flanke fließt der negative Stromsignalpuls I_{HL} (vgl. Figur 3) nicht mehr durch die Halbleiterstrahlungsquelle 100, sondern durch die Klemmschaltung 20 ab. Dadurch, dass dieser negative Strompuls nicht durch die Halbleiterstrahlungsquelle 100 fließt, wird verhindert, dass die Flussspannung an der Halbleiterstrahlungsquelle zu weit abgesenkt wird bzw. sich diese zu sehr entlädt, was einen folgenden Signalpuls verzögern würde.

Die über den Kontaktpunkt 5 mit der Kathode der Halbleiterstrahlungsquelle 100 verbundene Klemmschaltung 20 weist einen PNP-Transistor 21 auf, dessen Emitter über den Kontaktpunkt 5 mit der Kathode der Halbleiterstrahlungsquelle 100 verbunden ist. Die Basis des Transistors 21 ist mit dem negativen Pol einer Gleichspannungsquelle 22 verbunden. Der positive Pol der Gleichspannungsquelle 22 ist über einen Kontaktpunkt 24 mit einer Versorgungsspannung verbunden. Der Kollektoranschluss des Transistors 21 liegt auf dem konstanten Potentialpunkt 23.

Liegt nun die Spannung U_{HL} an der Halbleiterstrahlungsquelle 100 oberhalb eines bestimmten Grenzwertes, der durch die Stärke der Gleichspannungsquelle 22 eingestellt werden kann, so ist der Transistor 21 gesperrt. Dann fließt kein Strom durch den Transistor 21. Unterschreitet die Spannung U_{HL} an der Halbleiterstrahlungsquelle 100 jedoch diesen eingestellten Grenzwert, so wird der Transistor 21 automatisch leitend und der Strom I_{HL} an der Halbleiterquelle 100 fließt durch den p-Kanal des Transistors 21 zum konstanten Potentialpunkt 23 ab. Dadurch wird vermieden, dass die Flussspannung U_{HL} an der Halbleiterstrahlungsquelle 100 zu weit abgesenkt wird, was ein Wiedereinschalten der Halbleiterstrahlungsquelle 100 verzögern würde.

Die Erfindung beschränkt sich in ihrer Ausführung nicht auf die dargestellten Ausführungsbeispiele. Insbesondere ist die Realisierung der Klemmschaltung gemäß Figur 2 lediglich beispielhaft zu verstehen. Auch können anders aufgebaute Treiberschaltungen für die Halbleiterlaserdiode eingesetzt werden. Wesentlich ist allein, dass bei Unterschreiten eines vorgegebenen Werts der Flussspannung an der Halbleiterstrahlungsquelle das Peaking der abfallenden Signalflanke reduziert wird, so dass ein neuer Signalimpuls schneller ausgesandt werden kann.

### Bezugszeichenliste

- 1: Elektrische Schaltung
- 5: elektrischer Kontaktpunkt
- 11: Transistor der Peaking-Schaltung
- 12: Transistor
- 13: Masse
- 14: Kontaktpunkt mit Versorgungsspannung
- 15: Verbindung
- 17: ODER-Element
- 20: Klemmschaltung
- 20': Entladepulssteuerung
- 20'': Komparator
- 21: Transistor
- 22: Gleichspannungsquelle
- 23: Masse
- 100: Halbleiterstrahlungsquelle
- I_{HL}: Strom durch die Halbleiterstrahlungsquelle 100
- I_{HL,1}: erste Strompulsform
- I_{HL,2}: zweite Strompulsform
- U_{HL}: Spannung an der Halbleiterstrahlungsquelle 100
- U_{HL,1}: erste Spannungspulsform
- U_{HL,2}: zweite Spannungspulsform
- LICHT_{HL}: Lichtstrahlung der Halbleiterstrahlungsquelle 100
- LICHT_{HL,1}: erste Lichtpulsform
- LICHT_{HL,2}: zweite Lichtpulsform
- U₁₁: Spannung an Transistor 11
- U₁₂: Spannung an Transistor 12
- U₁₁': Spannung von Peaking-Schaltung an ODER-Element 17
- U₁₅: Spannung von Komparator 20'' an ODER-Element 17
- DC: Gleichspannungsquelle

## Patentansprüche

1. Elektrische Schaltung (1) für eine direkt modulierte Halbleiterstrahlungsquelle mit einer Halbleiterstrahlungsquelle (100), der in Abhängigkeit von einem digitalen Datensignal ein modulierter Strom (I_{HL}) zugeführt wird, dessen abfallende Signalflanke ein Peaking aufweist,
**gekennzeichnet durch**
Schaltungsmittel (20'; 20), die mit einem elektrischen Kontaktpunkt (5) der Schaltung (1) verbunden sind und bei Unterschreiten eines vorgegebenen Werts der Flussspannung (U_{HL}) an der Halbleiterstrahlungsquelle (100) ein Peaking der abfallenden Signalflanke reduzieren bzw. verhindern.

2. Schaltung nach Anspruch 1, **dadurch gekennzeichnet, dass** die Schaltungsmittel (20'; 20) den Strom (I_{HL}) durch die Halbleiterstrahlungsquelle (100) bei Unterschreiten des vorgegebenen Werts der Flussspannung mindestens teilweise umlenken oder abschalten.

3. Schaltung nach Anspruch 1 oder 2, **dadurch gekennzeichnet, dass** der für die Halbleiterstrahlungsquelle (100) bestimmte Strom (I_{HL}) durch die Schaltungsmittel (20) abfließt, wenn die Spannung (U_{HL}) an der Halbleiterstrahlungsquelle (100) den vorgegebenen Wert der Flussspannung unterschreitet.

4. Schaltung nach einem der vorangegangenen Ansprüche, **dadurch gekennzeichnet, dass** die Schaltungsmittel (20) mindestens einen Transistor (21) aufweisen, dessen Basis an einer Gleichspannungsquelle (22) liegt, die den vorgegebenen Wert der Flussspannung festlegt, und dessen Kollektor oder Emitter mit dem elektrischen Kontaktpunkt (5) verbunden ist.

5. Schaltung nach Anspruch 4, **dadurch gekennzeichnet, dass** der Strom durch die Halbleiterstrahlungsquelle bei Unterschreiten des vorgegebenen Werts der Flussspannung durch den Transistor (21) abgeleitet wird.

6. Schaltung nach einem der Ansprüche 3 bis 5, **dadurch gekennzeichnet, dass** die Schaltungsmittel (20) einen PNP-Transistor (21) aufweisen und die Halbleiterstrahlungsquelle (100) eine mit einem festen elektrischen Potential (13) verbundene Kathode aufweist, die mit dem Emitteranschluss des PNP-Transistors (21) verbunden ist.

7. Schaltung nach einem der Ansprüche 3 bis 5, **dadurch gekennzeichnet, dass** die Schaltungsmittel (20) einen NPN-Transistor aufweisen und die Halbleiterstrahlungsquelle (100) eine mit einem festen elektrischen Potential verbundene Anode aufweist, die mit dem Emitteranschluss des NPN-Transistors verbunden ist.

8. Schaltung nach einem der vorangegangenen Ansprüche, **dadurch gekennzeichnet, dass** die Schaltungsmittel eine Entladepulssteuerung (20') aufweisen, die das Peaking der abfallenden Signalflanke mittels einer entsprechenden Steuerung der Peaking-Pulse reduziert.

9. Schaltung nach Anspruch 8, **dadurch gekennzeichnet, dass** die Entladepulssteuerung (20') bei Unterschreiten eines vorgegebenen Werts der Flussspannung einer ein Peaking bereitstellenden Schaltung (11) ein Spannungs- oder Stromsignal zuführen, das ein Abschalten des Peakings der betrachteten Flanke bewirkt.

10. Schaltung nach Anspruch 9, **dadurch gekennzeichnet, dass** die Entladepulssteuerung (20') einen Komparator (20") aufweist, der die Spannung am elektrischen Kontaktpunkt (5) mit einem vorgegebenen Spannungswert vergleicht und bei Unterschreiten des vorgegebenen Werts ein Spannungs- oder Stromsignal erzeugt, das der ein Peaking bereitstellenden Schaltung (11) zugeführt wird.

11. Schaltung nach Anspruch 9 oder 10, **dadurch gekennzeichnet, dass** die ein Peaking bereitstellende Schaltung einen Transistor (11) aufweist und das Spannungsoder Stromsignal einer der Basis des Transistors (11) vorgeschalteten ODER-Schaltung zugeführt wird.

12. Schaltung nach einem der vorangegangenen Ansprüche, **dadurch gekennzeichnet, dass** die Schaltungsmittel (20; 20') eine elektrische Verbindung zu einem konstanten Potentialpunkt (23) aufweisen, insbesondere zu einer elektrischen Masse.
